Europäisches Patentamt

European Patent Office

Office européen des brevets

(11) Veröffentlichungsnummer : **0 277 536 B1**

# (12) EUROPÄISCHE PATENTSCHRIFT

(45) Veröffentlichungstag der Patentschrift :
03.04.91 Patentblatt 91/14

(51) Int. Cl.⁵ : **H05K 13/02, H01L 21/68**

(21) Anmeldenummer : **88100640.7**

(22) Anmeldetag : **19.01.88**

(54) Vorrichtung zum quasi-kontinuierlichen Behandeln von Substraten.

(30) Priorität : 30.01.87 DE 3702775

(43) Veröffentlichungstag der Anmeldung :
10.08.88 Patentblatt 88/32

(45) Bekanntmachung des Hinweises auf die
Patenterteilung :
03.04.91 Patentblatt 91/14

(84) Benannte Vertragsstaaten :
AT BE CH DE FR GB IT LI NL

(56) Entgegenhaltungen :
EP-A- 0 236 225
DD-A- 130 606
DE-A- 2 419 088
DE-A- 3 047 513
US-A- 4 599 026

(73) Patentinhaber : LEYBOLD
AKTIENGESELLSCHAFT
Wilhelm-Rohn-Strasse 25
W-6450 Hanau am Main 1 (DE)

(72) Erfinder : Mahler, Peter, Dipl.-Ing.
Gartenstrasse 95
W-6452 Hainburg (DE)

(74) Vertreter : Zapfe, Hans, Dipl.-Ing.
Am Eichwald 7
W-6056 Heusenstamm 2 Rembrücken (DE)

## Beschreibung

Die Erfindung betrifft eine Vorrichtung zum quasi-kontinuierlichen Behandeln, insbesondere zum Beschichten, von scheibenförmigen, in Kassetten angelieferten Substraten, mit einer Folge von Schleusen- und Behandlungskammern mit Behandlungseinrichtungen, mit einem Transportsystem für den Transport mindestens eines Substrathalters durch die Kammern und mit einer Chargierstation für die Be- und Entladung des Substrathalters mit bzw. von jeweils einem Substrat aus der bzw. in die Kassette.

Bei den Behandlungsverfahren kann es sich um sehr unterschiedliche Verfahren zur Beeinflussung des Beschichtungsprozesses und/oder des Schichtaufbaus und/oder der Substrateigenschaften handeln. Zu diesen Behandlungsverfahren gehören außer Beschichtungsverfahren auch Ätzverfahren, sowie Reinigungs- und Temperierverfahren ebenso wie Verfahren zur reaktiven Nachbehandlung von Schichten einschließlich definierter Abkühlverfahren.

Bei den scheibenförmigen Substraten kann es sich um kreisscheibenförmige Substrate wie CD- und Magnetplatten handeln, um angenähert kreisscheibenförmige Platten wie Wafer, oder aber auch um rechteckige oder quadratische Platten, wie sie für zahlreiche andere optische und/oder elektronische Zwecke benötigt werden. Bevorzugt ist die Vorrichtung jedoch für plattenförmige Substrate geeignet, deren äußere Umrißlinie mehr oder weniger einem Kreis entspricht.

Bei der quasi-kontinuierlichen Behandlung handelt es sich um eine solche, bei der die Substrate schrittweise, im Endergebnis aber ununterbrochen in die Vorrichtung eingeschleust und aus dieser wieder ausgeschleust werden. Ein zeitweiser Stillstand ist in der Regel durch die Schleusenkammern und/oder durch Stillstände während der einzelnen Behandlungsschritte bedingt.

Es ist bekannt, scheibenförmige Substrate, beispielsweise Wafer, in kassetten anzuliefern, die mit Halterungen zur Einhaltung von Abständen zwischen den einzelnen Substraten ausgestattet sind. Diese Halterungen bewirken auch eine senkrechte Lage der Haupt- bzw. Mittenebenen der einzelnen Substrate. Es hat sich jedoch bisher als schwierig erwiesen, die Substrate einzeln aus der Kassette herauszunehmen und in Substrathalter einzusetzen, sofern die Substrate mit senkrechter Ausrichtung zur Hauptebene durch die Vorrichtung transportiert werden sollen. Zu diesem Zweck muß nämlich der Substrathalter mit Halte- oder Rastvorrichtungen versehen sein, damit die Substrate nicht aus der Halterung herausfallen können. Dadurch war die Verwendung von automatischen Manipulatoren im wesentlichen stark eingeschränkt.

Der Erfindung liegt daher die Aufgabe zugrunde, eine Vorrichtung der eingangs beschriebenen Gattung dahingehend zu verbessern, daß sie mittels einer einfachen und zuverlässig arbeitenden automatischen Chargierstation am laufenden Band mit Substraten beschickt und wieder von den Substraten befreit werden kann, ohne daß die Substrate in allen Raumkoordinaten durch formschlüssige Halterungen gehalten werden müssen und/oder Gefahr laufen, aus den Substrathaltern herauszufallen.

Die Lösung der gestellten Aufgabe erfolgt bei der eingangs beschriebenen Vorrichtung erfindungsgemäß dadurch, daß

a) der Substrathalter mit Vorsprüngen für die Halterung jeweils eines scheibenförmigen Substrats lediglich durch Schwerkraft in einer Aufnahmeebene ausgestattet ist, die unter einem spitzen Winkel zu einer senkrechten Ebene verläuft, wobei gleichzeitig die besagte Aufnahmeebene parallel zu den Behandlungseinrich tungen verläuft, und daß

b) die Chargierstation eine Verschiebeeinrichtung für mindestens eine Kassette und eine im Verschiebebereich der Kassette angeordnete Manipulatoreinrichtung aufweist, durch die die Aushub- bzw. Einsatzbewegung des jeweiligen Substrats aus der bzw. in die Kassette in senkrechter Richtung durchführbar ist und durch die das Substrat durch eine Schwenkbewegung um 90 Grad in eine der Lage der Aufnahmeebene des Substrathalters im wesentlichen entsprechende Schräglage bringbar ist, in der das Substrat mittels der Manipulatoreinrichtung auf die Vorsprünge absetzbar bzw. von diesen abhhebbar ist.

Der spitze Winkel der Aufnahmeebene zur Senkrechten liegt dabei zweckmäßig zwischen 3 und 10 Grad, vorzugsweise zwischen 5 und 7 Grad.

Einerseits ist dieser Winkel relativ gering, so daß die Substrate zumindest nicht merklich durch Schwerkraft gebogen werden, andererseits reicht die geringe Schräglage durchaus aus, um das Substrat zuverlässig ausschließlich durch Schwerkraft auf den besagten Vorsprüngen zu halten und mittels des Substrathalters durch die gesamte Vorrichtung zu transportieren.

Die Vorsprünge lassen sich dabei ohne weiteres so ausbilden, daß sie weder den Behandlungsprozeß behindern, d.h. beim Beschichten eine Abschattung gegenüber dem Beschichtungsmaterial herbeiführen, noch den Wärmehaushalt bzw. das Wärmegleichgewicht zwischen Substrat und Substrathalter nachteilig beeinflussen.

Die Schwierigkeit besteht darin, daß die Substrate in der jeweiligen Kassette auf engstem Raum angeordnet sind, und ihre zu behandelnden Oberflächen sich jeweils gegenseitig verdecken, daß sie aber zum Zwecke ihrer Behandlung so angeordnet werden müssen, daß mindestens eine Oberfläche, gegebenenfalls sogar beide Oberflächen unbehindert dem Behandlungsprozeß ausgesetzt werden kann bzw. können.

Ein besonders vorteilhaftes Ausführungsbeispiel des Erfindungsgegenstandes ist dadurch gekennzeichnet, daß die Manipulatoreinrichtung eine Dreh- und Hubsäule mit einem Ausleger aufweist, an dem eine Greifvorrichtung für das Substrat angeordnet ist, und daß die Dreh- und Verschiebeachse der Säule in einer senkrechten Ebene liegt, die parallel zu den Ebenen der in der Kassette gelagerten Substrate verläuft und daß die Dreh- und Verschiebeachse in dieser Ebene unter einem spitzen Winkel zur Senkrechten verläuft, der im wesentlichen dem spitzen Winkel zwischen Aufnahmeebene und der Senkrechten entspricht.

Dabei ist es vorteilhaft, wenn der spitze Winkel der Dreh- und Verschiebeachse zur Senkrechten zwischen 2 und 9 Grad, vorzugsweise zwischen 4 und 6 Grad liegt.

Eine besonders platzsparende Vorrichtung der eingangs beschriebenen Gattung ist gemäß der weiteren Erfindung dadurch gekennzeichnet, daß die Folge von Schleusen- und Behandlungskammern in C-Form angeordnet ist, derart, daß die Behandlungskammern eine erste, fluchtende Reihe von aneinanderstossenden Kammern bilden und daß die Schleusenkammern eine zur ersten Reihe parallele, zweite fluchtende Reihe von Kammern bilden, wobei die zur Atmosphäre gerichteten Schleusenventile aufeinander zu gerichtet und und einen zu Chargierzwecken dienenden Abstand zwischen sich einschliessen, und daß schließlich die beiden Reihen an ihren jeweils benachbarten Enden durch je eine Quertransportkammer miteinande verbunden sind, in denen die Substrathalter durch eine Umsetzvorrichtung ohne Änderung ihrer Schräglage zu einer in Transportrichtung verlaufenden senkrechten Ebene von einem ersten Zweig des Transportsystems auf den hierzu parallelen zweiten Zweig des Transportsystems umsetzbar sind.

Es ist dabei besonders vorteilhaft, wenn die parallel zur Transportrichtung verlaufenden Außenwände und die wirksamen Oberflächen der Behandlungseinrichtungen ihrer Gesamtheit um einen spitzen Winkel gekippt angeordnet sind, der dem Anstellwinkel der Aufnahmeebene der Substrathalter entspricht.

Unter dem Ausdruck "wirksame Oberflächen der Behandlungseinrichtungen" wird bei plattenförmigen Elektroden zur Glimmreinigung bzw. zum Ätzen und bei plattenförmigen Targets zum Beschichten die zur Substratoberfläche planparallel verlaufende Oberfläche von Elektrode bzw. Target verstanden.

Weitere vorteilhafte Ausgestaltungen des Erfindungsgegenstandes ergeben sich aus den übrigen Unteransprüchen.

Ein Ausführungsbeispiel des Erfindungsgegenstandes wird nachfolgend anhand der Figuren 1 bis 10 näher erläutert.

Es zeigen :

Figur 1 eine Draufsicht auf eine Prinzipdarstellung der vollständigen Vorrichtung mit durch Pfeile eingezeichnetem Transportweg der Substrate,

Figur 2 einen Vertikalschnitt durch die Vorrichtung im Bereich der Chargierstationen,

Figur 3 einen Vertikalschnitt der Vorrichtung im Bereich der mit einer Heizeinrichtung versehenen ersten Vakuumschleuse,

Figur 4 einen Vertikalschnitt durch eine der Quertransportkammern zum Umsetzen der Substrathalter von einem Zweig des Transportsystems auf den jeweils anderen Zweig des Transportsystems,

Figur 5 einen Vertikalschnitt durch eine der Behandlungskammern mit einer Heizeinrichtung,

Figur 6 einen Vertikalschnitt durch den oberen Teil eines Substrathalters mit aufgesetztem Substrat in vergrößertem Maßstab,

Figur 7 eine halbe Vorderansicht des Gegenstandes nach Figur 6, jedoch ohne Substrat,

Figur 8 einen Vertikalschnitt durch eine Kassette in Verbindung mit der zugehörigen Manipulatoreinrichtung,

Figur 9 eine Draufsicht auf zwei unterschiedliche Kassetten in Verbindung mit einer zugehörigen Manipulatoreinrichtung und der Eingangsschleuse der Behandlungsvorrichtung und

Figur 10 einen Vertikalschnitt durch die Vorrichtung nach Figur 1 in vergrößertem Maßstab und mit weiteren Details im Bereich einer Behandlungsstation und der Eingangsschleuse entlang der Linie X-X in Figur 1.

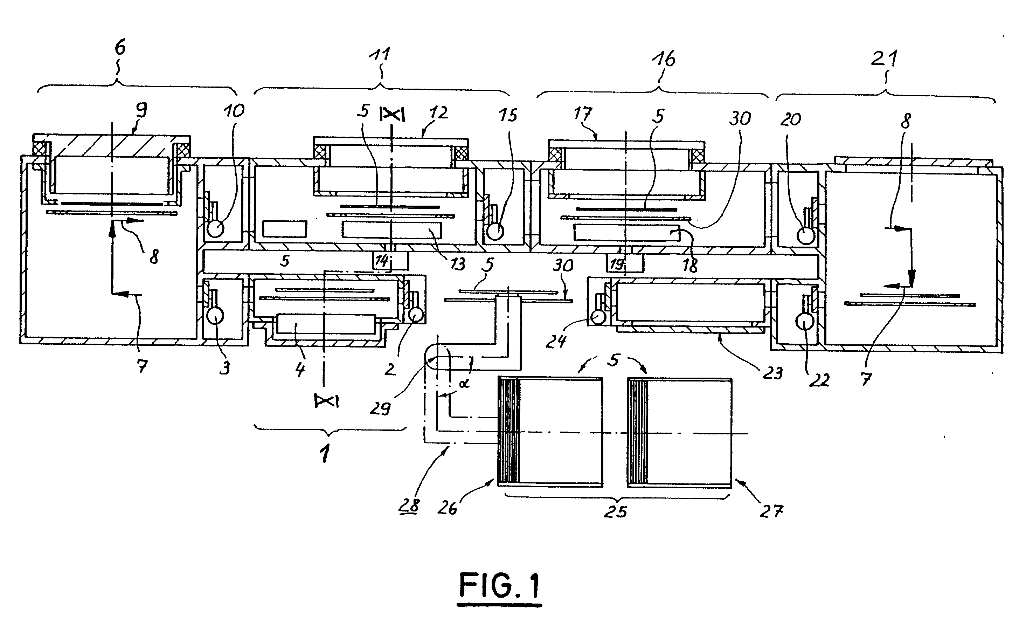

In Figur 1 ist das Bauprinzip der vollständigen Vorrichtung dargestellt. Diese Vorrichtung enthält eine Eingangsschleuse 1 mit Schleusenventilen 2 und 3 und einer Heizeinrichtung 4 zum Vorheizen eines Substrats 5.

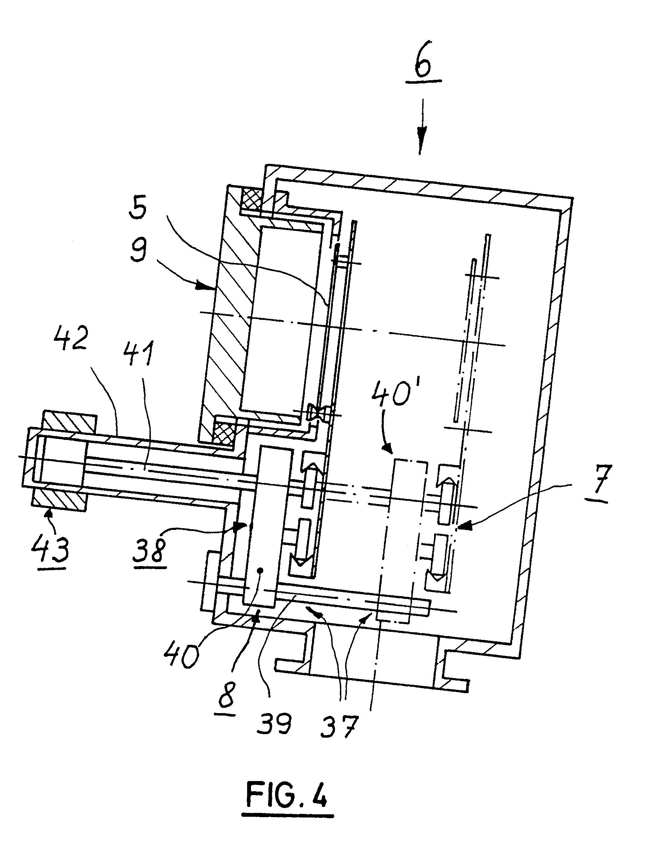

An die Eingangsschleuse 1 schließt sich eine Quertransportkammer 6 an, in der das Substrat in Richtung der eingezeichneten Pfeile von einem ersten Zweig 7 des Transportsystems auf einen zweiten Zweig 8 umsetzbar ist. Weitere Einzelheiten werden anhand der Figur 4 noch näher erläutert. In einer Seitenwand der Quertransportkammer 6 befindet sich noch eine Ätzvorrichtung 9, die in herkömmlicher Weise als Glimmentladungseinrichtung ausgebildet ist. Über ein weiteres Schleusenventil 10 schließt sich an die Quertransportkammer 6 eine Behandlungskammer 11 an, in deren einer Seitenwand sich eine Zerstäubungskatode 12 befindet, durch die das Substrat 5 mit einer ersten Beschichtung versehen werden kann. Auf der Rückseite des Substrats 5 befindet sich eine weitere Heizeinrichtung 13, der ein Temperaturfühler 14 zugeordnet ist.

An die Behandlungskammer 11 schließt sich über in Schleusenventil 15 eine weitere Behandlungskammer 16 an, die in ihrer einen Seitenwand eine weitere Zerstäubungskatode 17 trägt, mit der das Substrat 5 in analoger Weise beschichtet werden kann. Auf dieser Zerstäubungskatode gegenüber ist eine Heizeinrichtung 18 mit einem Temperaturfühler 19 angeordnet.

Die Behandlungskammer 16 ist über ein Schleusenventil 20 mit einer weiteren Quertransportkammer 21 verbunden, in der die Substrate in Richtung der eingezeichneten Pfeile vom Zweig 8 des Transportsystems wieder auf den Zweig 7 des Transportsystems umgesetzt werden. Die Quertransportkammern 6 und 21 haben gleichzeitig die Funktion von sogenannten Hochvakuumschleusen. Von der Quertransportkammer 21 führt ein Schleusenventil 22 zur Ausgangsschleuse 23, an dessen Ende wiederum ein Schleusenventil 24 vorgesehen ist. Über die beiden Schleusenventile 2 und 24 wird die Verbindung der Vorrichtung mit der Atmosphäre hergestellt. Das Transportsystem und sämtliche Schleusenventile sind durch eine nicht gezeigte und herkömmliche Zentraleinheit zwangsgesteuert.

Es ist erkennbar, daß die Folge von Schleusenkammern 1 und 23 und Behandlungskammern 11 und 16 in C-Form angeordnet ist, wobei die Behandlungskammern 11 und 16 eine erste fluchtende Reihe von aneinander stossenden Kammern bilden und die Schleusenkammern 1 und 23 eine zur ersten Reihe parallele, zweite fluchtende Reihe von Kammern bilden, und wobei die zur Atmosphäre gerichteten Schleusenventile 2 und 24 aufeinander zu gerichtet sind und einen zu Chargierzwecken dienenden Abstand zwischen sich einschliessen, auf den nachfolgend noch näher eingegangen werden wird.

Es ist weiterhin erkennbar, daß die beiden genannten Reihen an ihren jeweils benachbarten Enden durch jeweils eine der Quertransportkammern 6 und 21 miteinander verbunden sind, in denen die Substrathalter von einem ersten Zweig 7 des Transportsystems auf den hierzu parallelen zweiten Zweig 8 des Transportsystems umsetzbar sind und umgekehrt. Auf Einzelheiten der Umsetzvorrichtung wird in Verbindung mit Figur 4 noch näher eingegangen werden.

In Figur 1 ist ferner eine Chargierstation 25 gezeigt, in der sich zwei Kassetten 26 und 27 befinden, die hier nur durch die in ihnen befindlichen Substrate in Form von parallelen Strichen angedeutet sind. Zur Chargierstation 25 gehört eine hier nicht besonders hervorgehobene Verschiebeeinrichtung, die gleichfalls durch die genannte Zentraleinheit gesteuert wird, so daß jeweils ein aus einer Kassette entnommenes Substrat an eine genau vorher bestimmte Stelle der gleichen Kassette oder einer nachfolgenden Kassette gesetzt werden kann.

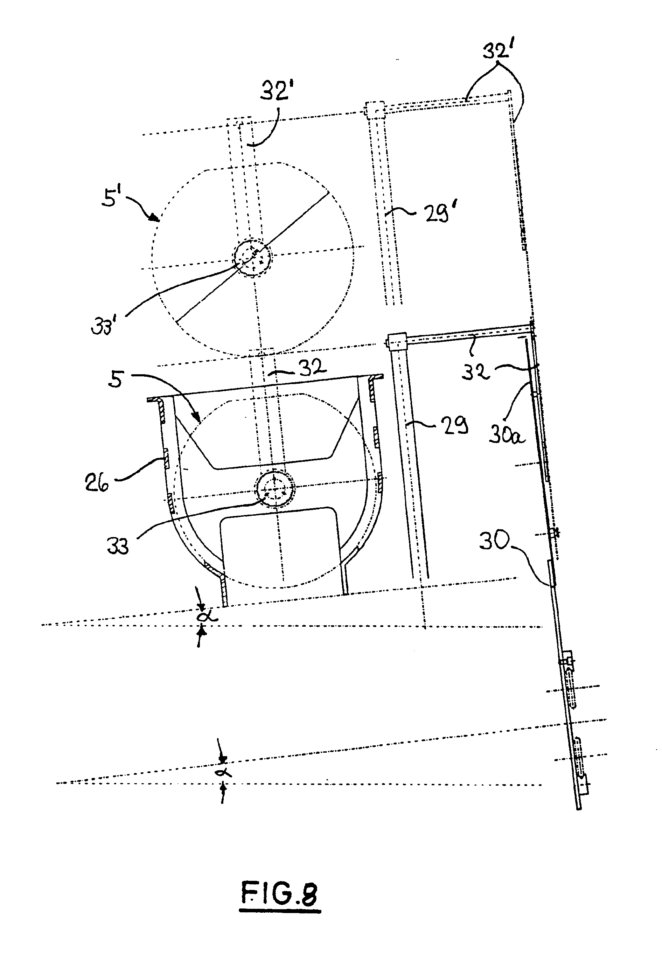

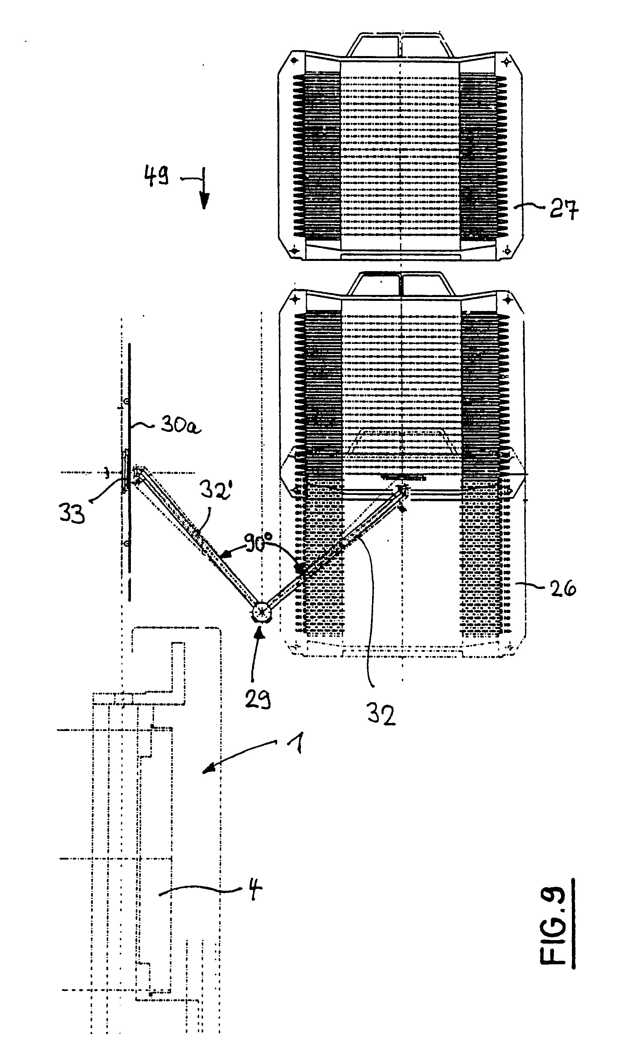

Im Bereich der Chargierstation 25 befindet sich weiterhin eine Manipulatoreinrichtung 28, auf deren Einzelheiten in Verbindung mit den Figuren 8 und 9 noch näher eingegangen wird. Zur Manipulatoreinrichtung gehört eine Dreh- und Hubsäule 29, die um einen Winkel α = 90 Grad schwenkbar ist. Durch diese Manipulatoreinrichtung 28 sind die Substrate 5 einzeln aus den Kassetten 26 bzw. 27 entnehmbar und in jeweils einen Substrathalter 30 einsetzbar, mit dem sie durch die gesamte Vorrichtung in Richtung der eingezeichneten Pfeile transportierbar sind. Der Substrathalter 30 ist wiederkehrend in verschiedenen Positionen dargestellt. Es versteht sich, daß eine derartige Vorrichtung regelmäßig mit mehreren Substrathaltern 30 ausgestattet ist, von denen sich mindestens einer im Bereich der Chargierstation befindet, während die anderen zyklisch durch die Vorrichtung transportiert werden.

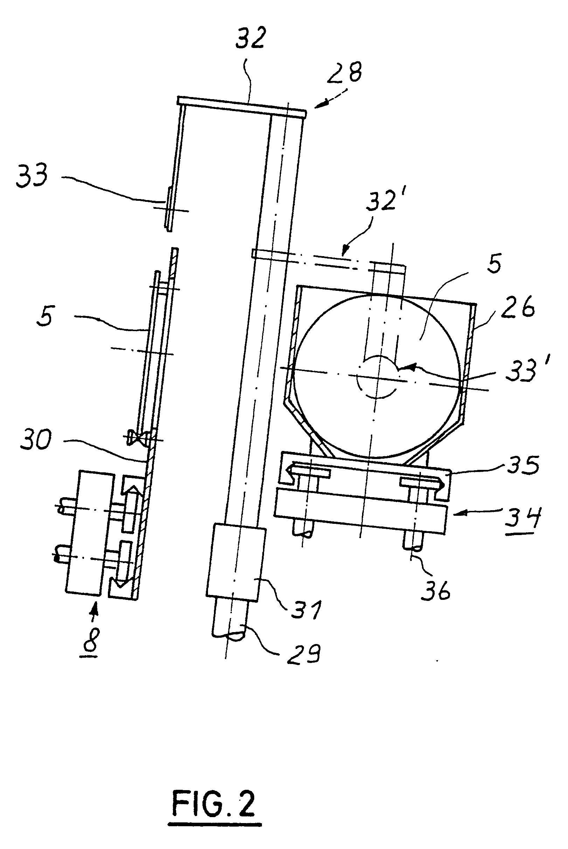

In Figur 2 ist das Zusammenwirken der Manipulatoreinrichtung 28 mit einer Kassette 26 und einem Substrathalter 30 in Übereinstimmung mit Figur 1 dargestellt. Die Dreh- und Hubsäule 29 ist in zwei Lagern 31 verdrehbar und in der Höhe verschiebbar gelagert, was an einem Ausleger 32 erkennbar ist, der in eine Stellung 32' gebracht werden kann. Am Ende dieses Auslegers 32 befindet sich eine Vakuumsauger 33 bzw. 33' für das Aufnehmen eines Substrats 5.

Die Kassette 26 ist auf einer Verschiebeeinrichtung 34 angeordnet, zu der eine Schlittenführung 35 gehört, durch die die Kassette 26 senkrecht zur Zeichenebene bewegbar ist. Der Antrieb erfolgt über nicht näher bezeichnete Transportrollen, von denen eine durch eine Welle 36 angetrieben wird. Die Transportrollen werden von der Schlittenführung 35 umfaßt.

Aus Figur 2 ist ersichtlich, daß die Dreh- und Hubsäule 29 unter einem spitzen Winkel zur Senkrechten verläuft, und zwar liegt sie in einer senkrechten Ebene (in der Zeichenebene), die parallel zu den Ebenen der in der Kassette 26 gelagerten Substrate 5 verläuft. Sie verläuft jedoch in dieser Ebene unter einem spitzen Winkel zur Senkrechten, der im wesentlichen dem spitzen Winkel zwischen Aufnahmeebene und der Senkrechten entspricht (Figur 8).

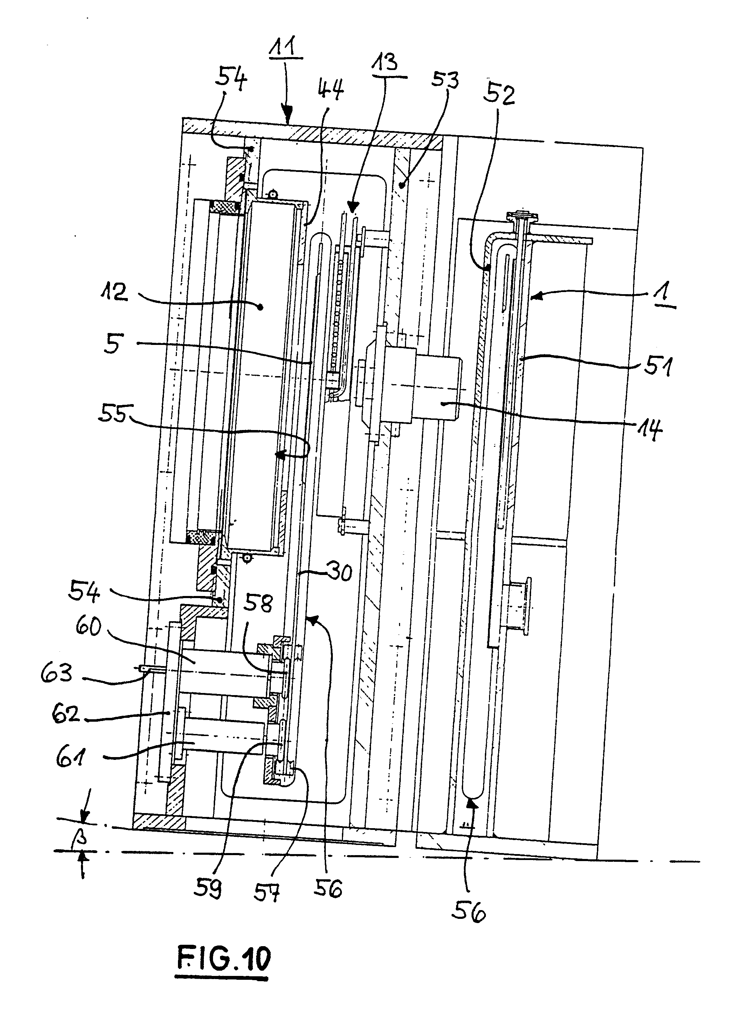

In Figur 2 sind Einzelheiten des zweiten Zweigs 8 des Transportsystems schematisch gezeigt. Bezüglich weiterer Einzelheiten wird jedoch auf Figur 10 verwiesen.

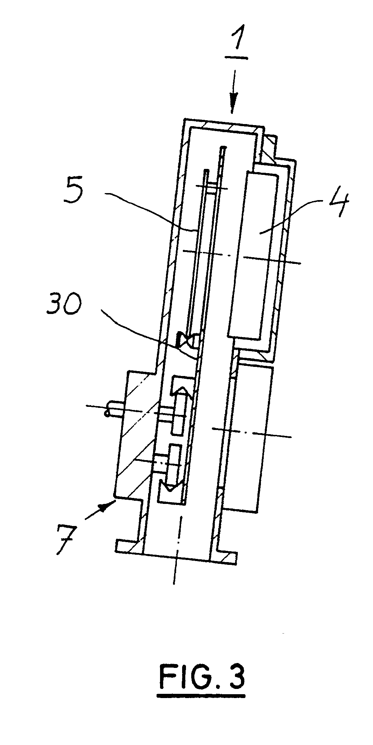

In Figur 3 ist ein Vertikalschnitt durch die Eingangsschleuse 1 mit dem ersten Zweig 7 des Transportsystems dargestellt.

Figur 4 zeigt einen Vertikalschnitt durch die Quertransportkammer 6, in der der erste Zweig 7 und der zweite Zweig 8 des Transportsystems 37 enden. In diesem Bereich besitzt die Umsetzvorrichtung 38 einen auf Achsen 39 quer verschiebbaren Rollenträger 40, der in die strichpunktiert dargestellte Position 40' auf den Achsen 39 verschiebbar ist. Am Rollenträger 40 sind zwei in Blickrichtung hintereinander liegende und nicht näher bezeichnete Paare von Rollen angeordnet, von denen mindestens eine durch eine Welle 41 antreibbar ist. Die Welle 41 liegt in einem vakuumdicht mit der Quertransportkammer 6 verbundenen Rohrstutzen 42 und trägt an ihrem Ende den inneren Teil einer Magnetkupplung 43, deren äußerer Teil auf dem Rohrstutzen 42 drehbar und in Längsrichtung verschiebbar ist. Auf diese Weise bleibt die Magnetkupplung unabhängig von der Lage des Rollenträgers 40 bzw. 40' stets im Eingriff. Die beiden in Figur 4 dargestellten Positionen 40 und 40' des Rollenträgers entsprechen der Fluchtstellung mit entsprechenden ortsfesten Rollenpaaren des ersten Zweiges 7 und des zweiten Zweiges 8 des Transportsystems 37.

Es ist erkennbar, daß der Substrathalter 30 mit dem Substrat 5 durch die in Figur 4 gezeigte Einrichtung von den ersten Zweig 7 auf den zweiten Zweig 8 des Transportsystems in Querrichtung umsetzbar ist.

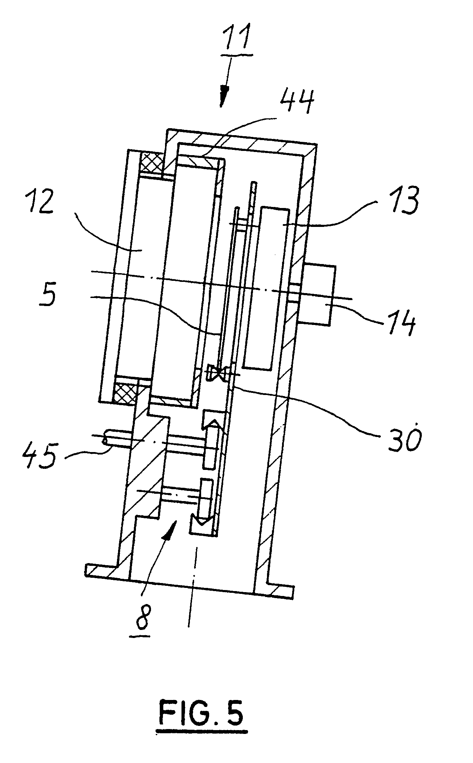

Figur 5 zeigt wiederum Einzelheiten im Bereich der Behandlungskammer 11, wobei zum Zwecke der Vermeidung von Wiederholungen auf Figur 1 verwiesen wird. Zur Zerstäubungskatode 12 gehört ein Erdungsschirm 44. Einzelheiten solcher Zerstäubungskatoden sind jedoch Stand der Technik, so daß sich ein näheres Eingehen hierauf erübrigt. Es ist noch gezeigt, daß eine der ortsfesten Rollen des zweiten Zweiges 8 des Transportsystems 37 mit einer Antriebswelle 45 versehen ist, um den Vorschub des Substrathalters 30 durch die Vorrichtung zu gewährleisten.

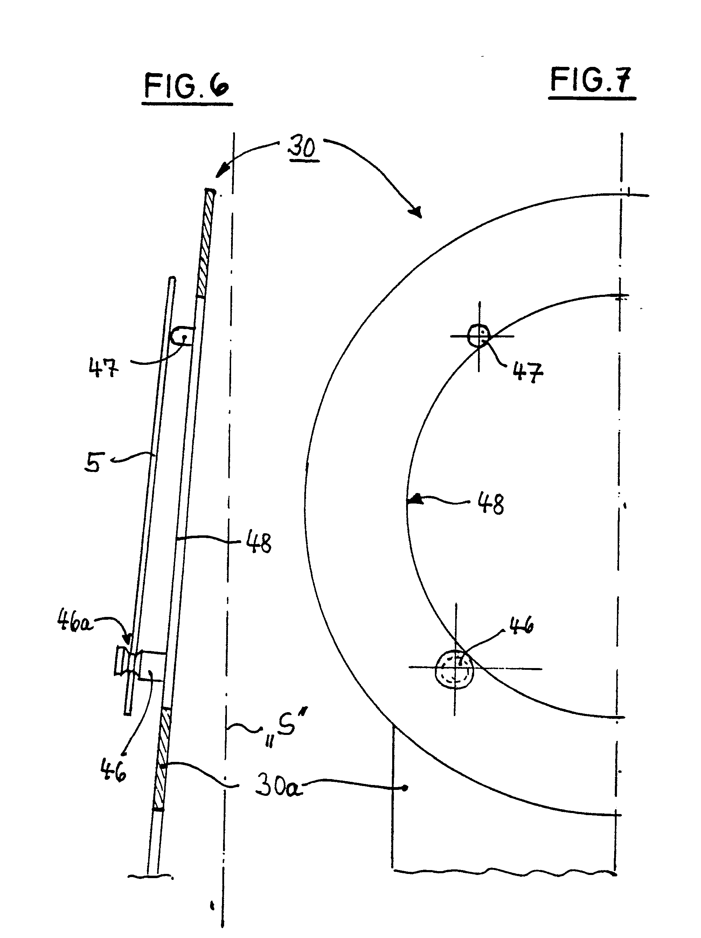

In den Figuren 6 und 7 ist der obere Teil des Substrathalters 30 dargestellt, und zwar in Figur 6 im Schnitt und in Figur 7 in der halben Draufsicht. Der Substrathalter ist paarweise mit unteren Vorsprüngen 46 und oberen Vorsprüngen 47 versehen, die am Rande einer kreisförmigen Ausnehmung 48 im Substrathalter 30 angeordnet sind. Der Substrathalter 30 besitzt eine Grundplatte 30a, die unter dem genannten spitzen Winkel zu einer Senkrechten "S" verläuft und parallel zu sich selbst in Transportrichtung in Figur 6 (senkrecht zur Zeichenebene) verschiebbar ist. Die Grundplatte 30a ist im unteren Bereich des Substrats 5 mit den beiden genannten Vorsprüngen 46 versehen, die mit je einer Nut 46a für die Aufnahme des unteren Substratrandes versehen sind. Im oberen Bereich des Substrats sind die beiden Vorsprünge 47 angeordnet, deren Stirnseiten zur Auflage des Substrats dienen, derart, daß das Substrat 5 im Abstand von der Grundplatte 30a gehalten ist. Auf diese Weise ist der Vakuumsauger 33 in den Zwischenraum zwischen der Grundplatte 30a und dem Substrat 5 einführbar. Die kreisförmige Ausnehmung 48 dient dazu, daß die Rückseite des Substrats 5 ungehindert in Wechselwirkung mit einer Behandlungseinrichtung, beispielsweise mit einer Quelle für Wärmestrahlung, treten kann.

In Figur 8 ist die Funktionsweise der Manipulatoreinrichtung 28 in vergrößertem Maßstab in entgegengesetzter Blickrichtung wie in Figur 2 dargestellt. Die Dreh- und Hubsäule 29 kann in der links dargestellten Stellung des Auslegers 32 zusammen mit dem Vakuumsauger 33 in den Zwischenraum zwischen zwei Substraten innerhalb der Kassette 46 eingeführt werden, wobei die Hauptebenen dieser Substrate genau senkrecht verlaufen. Durch Anheben der Dreh- und Hubsäule 29 in die gestrichelt dargestellte Position 29' läßt sich eines der Substrate 5' aus der Kassette 26 entnehmen. Infolge der unter dem Winkel α vorgenommenen Schrägstellung der Dreh- und Hubsäule 29 gelangt das Substrat 5 bzw. 5' durch eine Drehung des Auslegers 32 bzw. 32' um 90 Grad in eine Winkelstellung, die der Schräglage der Dreh- und Hubsäule 29 entspricht. In dieser Stellung kann das Substrat 5 bzw. 5' auf den weiter oben beschriebenen Vorsprüngen des Substrathalters 30 abgesetzt werden. Die Winkelstellung der Dreh- und Hubsäule 29 zur Senkrechten "S" wird dabei bevorzugt um 1 Grad geringer gehalten, damit das Substrat ohne Gleitvorgänge auf den Stirnseiten der Vorsprünge 47 auf die Vorsprünge 46 und 47 aufgesetzt werden kann.

Figur 9 zeigt nochmals die Verhältnisse gemäß Figur 8 in der Draufsicht, wobei die Blickrichtung in Figur 8 durch den Pfeil 49 angegeben ist.

Aus Figur 10 gehen einige weitere Details der Anlagenkonstruktion hervor.

Da die meisten der hier in Frage kommenden Behandlungsvorgänge unter Vakuum und/oder Schutzgas durchgeführt werden, werden die Schleusen- und Behandlungskammern etc. durch sogenannte Vakuumkammern gebildet. Deren parallel zur Transportrichtung verlaufende Außenwände 51, 52 bzw. 53, 54 und die eingangs beschriebenen wirksamen Oberflächen 55 der Behandlungseinrichtungen sind in ihrer Gesamtheit um einen spitzen Winkel ß gekippt, der dem Anstellwinkel der Aufnahmeebene der Substrathalter 30 entspricht. Die Raumlage dieser Aufnahmeebene wird gemäß Figur 6 durch die Nuten 46a der Vorsprünge 46 und durch die nicht näher bezeichneten Stirnseiten der Vorsprünge 47 definiert, wobei der Einfachheit halber zunächst die Dicke des Substrats 5 vernachlässigt werden soll. Die Lage dieser Aufnahmeebene entspricht somit der Lage der Substrate 5, wie sich eindeutig aus Figur 6 ergibt. Die einzelnen Behandlungskammern sind durch Schlitzöffnungen 56 miteinander verbunden, die zumindestens teilweise durch die in Figur 1 gezeigten Schleusenventile absperrbar sind.

Jeder Substrathalter 30 besitzt in seinem unteren Bereich vier zueinander parallel und waagrecht ausgerichtete Führungsleisten 57, die mittels nicht näher bezeichneter prismatischer Laufflächen formschlüssig auf paarweise angeordneten Transportrollen 58 und Führungsrollen 59 aufsetzbar sind. Transport- und Führungsrollen 58 bzw. 59 sind in ortsfesten Lagerhülsen 60 bzw. 61 gelagert, die fest mit einer Flanschplatte 62 verbunden sind. Die Transportrolle 58 ist durch eine Welle 63 antreibbar.

Die Rollen 58/59 sowie die in Blickrichtung gemäß Figur 10 davor und dahinter liegenden weiteren Rollen definieren den zweiten Zweig 8 des Transportsystems. Der erste Zweig 7 des Transportsystems wird durch in Figur 10 nicht gezeigte weitere Paare von Rollen definiert, die dort in spiegelsymmetrischer Anordnung zu finden sind, insbesondere auch in der Eingangsschleuse 1. Im Zusammenhang mit Figur 4 und den zugehörigen Erläuterungen ergibt sich auch, auf welche Weise sämtliche Substrathalter 30 von den Rollen des ersten Zweiges 7 auf die Rollen des zweiten Zweiges 8 umsetzbar sind.

## Ansprüche

1. Vorrichtung zum quasi-kontinuierlichen Behandeln, insbesondere zum Beschichten von scheibenförmigen, in Kassetten angelieferten Substraten, mit einer Folge von Schleusen- und Behandlungskammern, mit Behandlungseinrichtungen mit einem Transportsystem für den Transport mindestens eines Substrathalters durch die Kammern und mit einer Chargierstation für die Be- und Entladung des Substrathalters mit bzw. von jeweils einem Substrat aus der bzw. in die Kassette, dadurch gekennzeichnet, daß

a) der Substrathalter (30) mit Vorsprüngen (46, 47) für die Halterung jeweils eines scheibenförmigen Substrats (5) lediglich durch Schwerkraft in einer Aufnahmeebene ausgestattet ist, die unter einem spitzen Winkel zu einer senkrechten Ebene verläuft, wobei gleichzeitig die besagte Aufnahmeebene parallel zu den Behandlungseinrichtungen verläuft, und daß

b) die Chargierstation (25) eine Verschiebeeinrichtung (34) für mindestens eine Kassette (26, 27) und eine im Verschiebebereich der Kassette (26, 27) angeordnete Manipulatoreinrichtung (28) aufweist, durch die die Aushub- bzw. Einsatzbewegung des jeweiligen Substrats (5) aus der bzw. in die Kassette (26, 27) in senkrechter Richtung durchführbar ist und durch die das Substrat durch eine Schwenkbewegung um 90 Grad in eine der Lage der Aufnahmeebene des Substrathalters (30) im wesentlichen entsprechende Schräglage bringbar ist, in der das Substrat (5) mittels der Manipulatoreinrichtung auf die Vorsprünge absetzbar bzw. von diesen abhebbar ist.

2. Vorrichtung nach Anspruch 1, dadurch gekennzeichnet, daß der spitze Winkel der Aufnahmeebene zur Senkrechten zwischen 3 und 10 Grad, vorzugsweise zwischen 5 und 7 Grad, liegt.

3. Vorrichtung nach Anspruch 1, dadurch gekennzeichnet, daß die Manipulatoreinrichtung (28) eine Dreh- und Hubsäule (29) mit einem Ausleger (32) aufweist, an dem eine Greifvorrichtung (33) für das Substrat (5) angeordnet ist, und daß die Dreh- und Verschiebeachse der Säule (29) in einer senkrechten Ebene liegt, die parallel zu den Ebenen der in der Kassette (26, 27) gelagerten Substrate (5) verläuft und daß die Dreh- und Verschiebeachse in dieser Ebene unter einem spitzen Winkel zur Senkrechten verläuft, der im wesentlichen dem spitzen Winkel zwischen Aufnahmeebene und der Senkrechten entspricht.

4. Vorrichtung nach Anspruch 3, dadurch gekennzeichnet, daß der spitze Winkel der Dreh- und Verschiebeachse der Säule (29) zur Senkrechten zwischen 2 und 9 Grad, vorzugsweise zwischen 4 und 6 Grad, liegt.

5. Vorrichtung nach Anspruch 3, dadurch gekennzeichnet, daß die Greifvorrichtung (33) ein Vakuumsauger ist.

6. Vorrichtung nach Anspruch 1, dadurch gekennzeichnet, daß der Substrathalter (30) eine Grundplatte (30a) aufweist, die unter dem genannten spitzen Winkel zur Senkrechten ("S") verläuft, und parallel zu sich selbst in Transportrichtung verschiebbar ist, und daß die Grundplatte (30a) im unteren Bereich des Substrats (5) zwei Vorsprünge (46) mit je einer Nut (46a) für die Aufnahme des unteren Substratrandes und im oberen Bereich des Substrats zwei Vorsprünge (47) mit Stirnseiten für die Auflage des Substrats (5) aufweist, derart, daß das Substrat (5) im Abstand von der Grundplatte (30a) gehalten ist.

7. Vorrichtung nach Anspruch 6, dadurch gekennzeichnet, daß die Greifvorrichtung (33) für das Substrat (5) auf dessen Rückseite in den Zwischenraum zwischen Substrat und Grundplatte (30a) einführbar ist.

8. Vorrichtung nach Anspruch 1, dadurch gekennzeichnet, daß die Folge von Schleusen- (1, 23) und Behandlungskammern (11, 16) in C-Form angeordnet ist, derart, daß die Behandlungskammern (11, 16) eine erste, fluchtende Reihe von aneinanderstossenden Kammern bilden und daß die Schleusenkammern (1, 23) eine zur ersten Reihe parallele, zweite, fluchtende Reihe von Kammern bilden, wobei die zur Atmosphäre gerichteten Schleusenventile (2, 24) aufeinander zu gerichtet sind und einen zu Chargierzwecken dienenden Abstand zwischen sich einschliessen, und daß schließlich die beiden Reihen an ihren jeweils benachbarten Enden durch je eine Quertransportkammer (6, 21) miteinander verbunden sind, in denen die Substrathalter (30) durch eine Umsetzvorrichtung (38) ohne Änderung ihrer Schräglage zu einer in Transportrichtung verlaufenden senkrechten Ebene von einem ersten Zweig (7) des Transportsystems auf den hierzu parallelen zweiten Zweig (8) des Transportsystems umsetzbar sind.

9. Vorrichtung nach einem der Ansprüche 1 oder 8, dadurch gekennzeichnet, daß die parallel zur Transporteinrichtung verlaufenden Außenwände (51, 52 ; 53, 54) und die wirksamen Oberflächen (55) der Behandlungseinrichtungen in ihrer Gesamtheit um einen spitzen Winkel "β" gekippt angeordnet sind, der dem Anstellwinkel der Aufnahmeebene der Substrathalter (30) entspricht.

10. Vorrichtung nach Anspruch 8, <u>dadurch gekennzeichnet</u>, daß jeder Substrathalter (30) in seinem unteren Bereich zueinander parallele, waagrecht ausgerichtete Führungsleisten (57) aufweist, die mittels Laufflächen formschlüssig auf paarweise angeordnete Transport- (58) und Führungsrollen (59) aufsetzbar sind, und daß die Umsetzvorrichtung (38) einen quer verschiebbaren Rollenträger (40) mit mindestens zwei Rollenpaaren aufweist, die wahlweise mit ortsfesten Rollenpaaren des ersten (7) und des zweiten Zweiges (8) des Transportsystems (37) in Fluchtstellung bringbar sind.

11. Vorrichtung nach Anspruch 10, <u>dadurch gekennzeichnet</u>, daß mindestens eine der Rollen des verschiebbaren Rollenträgers (40) mit einer Antriebswelle (41) versehen ist, die mit einem Antrieb (43) zur Übertragung eines Drehmoments und einer Schubkraft zur Querverschiebung des Rollenträgers (40) verbunden ist.

12. Vorrichtung nach Anspruch 11, <u>dadurch gekennzeichnet</u>, daß die Antriebswelle (41) mit einem inneren Element einer Magnetkupplung (43) versehen ist, das in einen aus amagnetischen Werkstoff bestehenden Rohrstutzen (42) hineinragt, auf dessen Außenseite ein äußeres Element der Magnetkupplung (43) drehbar und axial verschiebbar angeordnet ist.

## Claims

1. Device for quasi-continuous treatment, particularly for coating disc-type substrates delivered in cassettes, with a series of air-lock and treatment chambers with treatment facilities, with a conveyor system for the transportation of at least one substrate holder through the chambers and with a loading station for loading and unloading the substrate holder with the respective substrate into or out of the cassette, <u>characterised in that</u>,

   a) the substrate holder (30) is equipped with projections (46, 47) for holding a disc-type substrate (5) in a receiving plane under the force of gravity only, said projections running at an acute angle to a vertical plane, whereby at the same time the said receiving plane runs parallel to the treatment facilities and that

   b) the loading station (25) has a translation device (34) for at least one cassette (26, 27) and a manipulation device (28) arranged within the translation range of the cassette (26, 27), via which the respective substrate (5) can be lifted out of or inserted into the cassette vertically and via which the substrate can be brought to a position which is essentially inclined to the receiving plane of the substrate holder (30) by means of a rotating movement through 90 degrees, in which position the substrate (5) can be set down on or lifted up from the projections by means of the manipulation device.

2. Device according to claim 1, characterised in that, the acute angle of the receiving plane to the vertical is between 3 and 10 degrees, and preferably between 5 and 7 degrees.

3. Device according to claim 1, <u>characterised in that</u>, the manipulation device (28) has a rotating and lifting column (29) with an extension arm (32) on which is arranged a gripping device (33) for the substrate (5), and that the rotary and sliding axis of the column (29) lies in a vertical plane which runs parallel to the planes of the substrates (5) stored in the cassette (26, 27), and that in this plane the rotary and sliding axis is at an acute angle to the vertical, which essentially corresponds to the acute angle between the receiving plane and the vertical.

4. Device according to claim 3, <u>characterised in that</u>, the acute angle between the rotary and sliding axis of the column (29) and the vertical is between 2 and 9 degrees, and preferably between 4 and 6 degrees.

5. Device according to claim 3, <u>characterised in that</u>, the gripping device (33) is a vacuum suction device.

6. Device according to claim 1, <u>characterised in that</u>, the substrate holder (30) has a base plate (30a) which runs at the said acute angle to the vertical ("S"), and can be moved parallel to itself in the conveyed direction, and that in the lower part of the substrate (5) the base plate (30a) has two projections, each with a slot (46a), to receive the lower edge of the substrate and in the upper part of the substrate has two projections (47) with faces to support the substrate (5), such that the substrate (5) is maintained at a distance from the base plate (30a).

7. Device according to claim 6, <u>characterised in that</u>, the gripping device (33) for the substrate (5) can be inserted at the rear side of the latter in the space between substrate and base plate (30a).

8. Device according to claim 1, <u>characterised in that</u>, the series of air-lock (1, 23) and treatment chambers (11, 16) are C-shaped, such that the treatment chambers (11, 16) form a first, aligned row of contiguous chambers and that the air-lock chambers (1, 23) form a second, aligned row of contiguous chambers parallel to the first row, whereby the air-lock valves (2, 24) directed to the atmosphere shall be aligned with each other and form a space between themselves for loading purposes, and that finally the two rows are connected together at their respective adjacent ends by transverse conveying chambers (6, 21) in which the substrate holders (30) may be transferred from a first branch (7) of the conveyor system to the second branch (8) of the conveyor system parallel to it by means of a transfer device (38) without changing their inclined position to a plane running vertically to the conveying direction.

9. Device according to one of claims 1 or 8, characterised in that, the outer walls (51, 52 ; 53, 54) running parallel to the conveying direction and the effective surfaces (55) of the treatment facilities are all inclined at an acute angle "B" which corresponds to the angle of incidence of the receiving plane of the substrate holder (30).

10. Device according to claim 8, characterised in that, the lower part of each substrate holder (30) has parallel, horizontally-aligned guide rails (57) which, via bearing surfaces, can be positively located on conveyor (58) and guide rollers (59) arranged in pairs, and that the transfer device (38) has a transverse sliding roller carriage (40) with at least two pairs of rollers which can be brought into alignment with fixed pairs of rollers of either the first (7) or second branch (8) of the conveyor system (37).

11. Device according to claim 10, characterised in that, at least one of the rollers of the sliding roller carriage (40) is fitted with a drive shaft (41) which is connected to a drive (43) for transmitting a torque and a thrust to impart transverse movement to the roller carriage (40).

12. Device according to claim 11, characterised in that, the drive shaft (41) is fitted with an inner element of a magnetic clutch (43), which projects into a section of tube (42) of non-magnetic material, on whose outer side an external element of the magnetic clutch (43) can be rotated and displaced in an axial direction.

## Revendications

1. Dispositif pour le traitement quasi-continu, en particulier pour le revêtement de substrats en forme de disque acheminés dans des cassettes, comprenant une succession de chambres de sas et de traitement, des dispositifs de traitement, et un système de transport servant à faire circuler au moins un porte-substrat à travers les chambres, et un poste de chargement destiné à charger et décharger le porte-substrat d'un substrat extrait de la cassette ou réintroduit dans la cassette, caractérisé en ce que,

a) le porte-substrat (30) est muni de saillies (46, 47) servant à tenir un substrat (5) en forme de disque uniquement par gravité dans un plan de réception qui forme un angle aigu avec un plan vertical, ledit plan de réception s'étendant en même temps parallèlement aux dispositifs de traitement, et en ce que

b) le poste de chargement (25) présente un dispositif de transalation (34) destiné à agir sur au moins une cassette (26, 27) et un dispositif manipulateur (28) disposé dans la zone de translation de la cassette (26, 27), qui peut effectuer le mouvement d'extraction ou d'insertion des substrats (5) considérés hors de la cassette (26, 27) ou dans cette cassette dans la direction verticale et qui peut placer le substrat, par un mouvement de pivotement de 90°, dans une position oblique qui correspond essentiellement au plan de réception du porte-substrat (30), et dans laquelle le substrat (5) peut être déposé sur les saillies ou enlevé de ces saillies à l'aide du dispositif manipulateur.

2. Dispositif selon la revendication 1, caractérisé en ce que l'angle aigu que le plan de réception forme avec la verticale est compris entre 3 et 10°, de préférence entre 5 et 7°.

3. Dispositif selon la revendication 1 caractérisé en ce que le dispositif manipulateur (28) comprend une colonne rotative et élévatrice (29) munie d'un bras en porte-à-faux (32) sur lequel est agencé un dispositif de préhension (33) servant à prendre le substrat (5) et en ce que l'axe de rotation et translation de la colonne (29) se trouve dans un plan vertical qui s'étend parallèlement aux plans des substrats (5) logés dans la cassette (26, 27), et en ce que l'axe de rotation et de translation s'étend dans ce plan en formant un angle aigu avec la verticale, cet angle correspondant sensiblement à l'angle aigu formé entre le plan de réception et la verticale

4. Dispositif selon la revendication 3, caractérisé en ce que l'angle aigu que l'axe de rotation et de translation de la colonne (9) forme avec la verticale est compris entre 2 et 9°, de préférence entre 4 et 6°.

5. Dispositif selon la revendication 3, caractérisé en ce que le dispositif de préhension (33) est une ventouse.

6. Dispositif selon la revendication 1, caractérisé en ce que le porte-substrat (30) comprend une plaque de base (30a) qui forme ledit angle aigu avec la verticale ("S") et peut se déplacer parallèlement à lui-même dans la direction du transport, et en ce que la plaque de base (30a) présente, dans la région inférieure du substrat (5), deux saillies (46) présentant chacune une rainure (46a) destinée à recevoir le bord intérieur du substrat et présente, dans la région supérieure du substrat, deux saillies (47) possédant des faces frontales destinées à donner appui au substrat (5), de telle manière que le substrat (5) soit tenu à distance de la plaque de base (30a).

7. Dispositif selon la revendication 6, caractérisé en ce que le dispositif de préhension (33) destiné à saisir le substrat (5) peut être inséré contre la face arrière de ce substrat, dans l'espace intermédiaire compris entre le substrat et la plaque de base (30a)

8. Dispositif selon la revendication 1, caractérisé en ce que la succession de chambres de sas (1, 23) et de chambres de traitement (11, 16) est disposée en forme de C, de sorte que les chambres de traitement (11, 16) forment une première rangée, alignée, de chambres juxtaposées entre elles, et en ce que les chambres de sas (1, 23) forment une deuxième rangée de chambres, alignée parallèle à la première rangée, les soupapes de sas (2, 24) dirigées vers l'atmosphère étant dirigées les unes vers les autres et enfermant entre elles un espace qui sert aux opérations de chargement et en ce que, finalement, les deux rangées sont reliées entre elles et l'une à l'autre, à leurs extrémités mutuellement adjacentes par une chambre de transport transversal (6, 21) dans laquelle les porte-substrats (30) peuvent être aiguillés par un dispositif d'aiguillage (38), sans modification de leur position oblique, dans un plan vertical s'étendant dans la direction du transport, d'une première branche (7) du système de transport à la deuxième branche (8) du système de transport qui est parallèle à la première.

9. Dispositif selon une revendication 1 et 8, caractérisé en ce que les parois extérieures (51, 52 ; 35, 54) qui s'étendent parallèlement au dispositif de transport et les surfaces effectives (55) des dispositifs de traitement sont disposés dans une position basculée d'un angle aigu "β",qui correspond à l'angle d'incidence du plan de réception des porte-substrats (30).

10. Dispositif selon la revendication 8, caractérisé en ce que chaque porte-substrat (30) présente, dans sa région inférieure, des languettes de guidage (57) parallèles entre elles, orientées horizontalement, qui peuvent être posées, à l'aide surfaces de circulation, par sûreté de forme, sur des galets de transport (38) et de guidage (59) disposés par paires et en ce que le dispositif d'aiguillage (38) présente un support de galets (40), mobile en translation tranversale, qui comprend au moins deux paires de galets qui peuvent être placées sélectivement dans une position d'alignement avec les paires de galets fixes de la première branche (7) et de la deuxième branche (8) du système de transport (37).

11. Dispositif selon la revendication 10, caractérisé en ce qu'au moins un des galets du support de galets (40) mobile en translation est muni d'un arbre d'entraînement (41) qui est relié à un entraînement (43) pour transmettre un couple et une force de translation pour la translation transversale de support de galets (40).

12. Dispositif selon la revendication 11, caractérisé en ce que l'arbre d'entraînement (41) est muni de l'élément intérieur d'un embrayage électromagnétique (43) qui pénètre dans une tubulure (42) composée d'une matière amagnétique sur la face extérieure de laquelle un élément extérieur de l'embrayage magnétique (43) est monté mobile et translation axiale.

EP 0 277 536 B1

**FIG.1**

FIG.2

FIG. 3

FIG. 4

FIG.5

# FIG.6

# FIG.7

FIG.8

FIG.9

**FIG.10**